(19) **Europäisches Patentamt / European Patent Office / Office européen des brevets**

(11) **EP 4 343 990 A1**

(12) **EUROPEAN PATENT APPLICATION**
published in accordance with Art. 153(4) EPC

(43) Date of publication:
**27.03.2024 Bulletin 2024/13**

(21) Application number: **22804587.8**

(22) Date of filing: **12.05.2022**

(51) International Patent Classification (IPC):
**H01S 5/183** (2006.01)  **G01C 3/06** (2006.01)
**G01S 7/481** (2006.01)  **G01S 7/484** (2006.01)
**H01S 5/02325** (2021.01)  **H01S 5/062** (2006.01)

(52) Cooperative Patent Classification (CPC):
**G01C 3/06; G01S 7/481; G01S 7/484;
H01S 5/02325; H01S 5/062; H01S 5/183**

(86) International application number:
**PCT/JP2022/020072**

(87) International publication number:
**WO 2022/244674 (24.11.2022 Gazette 2022/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.05.2021 JP 2021083105
11.04.2022 JP 2022065143**

(71) Applicant: **CANON KABUSHIKI KAISHA**
**Tokyo 146-8501 (JP)**

(72) Inventors:
• **UCHIDA, Takeshi**
  **Tokyo 146-8501 (JP)**
• **SUGA, Takako**
  **Tokyo 146-8501 (JP)**

(74) Representative: **TBK**
**Bavariaring 4-6
80336 München (DE)**

(54) **LIGHT-EMITTING DEVICE, RANGING DEVICE, AND MOVABLE BODY**

(57) An object is to provides a light emitting device capable of generating a light pulse having a short light pulse width and a high peak value. The light emitting device includes a semiconductor light emitting element including a first reflector, a resonator spacer including an active layer, and a second reflector stacked in this order over a semiconductor substrate. The semiconductor light emitting element includes a saturable absorption layer provided between the semiconductor substrate and the second reflector. The semiconductor light emitting element is configured to emit light having a profile that has a maximum peak value and converges to a stable value of a predetermined light intensity after the maximum peak value.

FIG. 1

EP 4 343 990 A1

**Description**

[Technical Field]

The present invention relates to a light emitting device, a ranging device, and a movable object.

[Background Art]

PTL 1 describes that VCSEL (Vertical Cavity Surface Emitting LASER) is used as a light source for a LiDAR (Light Detection and Ranging) device using a ToF (Time of Flight) system. The VCSEL has an advantage in that the wavelength dependency with respect to temperature is small.
By the way, in the above-described system, it becomes easy to distinguish the ambient light and the light pulse emitted by itself on the light-receiving side by increasing the peak value of the light pulse to be irradiated, whereby the S/N ratio can be increased, and consequently, the maximum measurable distance can be extended. On the other hand, from the viewpoint of eye safety, the peak value of the light pulse is limited. The upper limit of the peak value from the viewpoint of eye safety depends on the width of the light pulse, and the peak value can be increased as the width of the light pulse becomes narrower. Therefore, as a light source applied to the LiDAR system, a light source capable of generating a light pulse having a short light pulse width and a high peak value is desirable.

[Citation List]

[Patent Literature]

PTL 1: Japanese Patent Application Laid-Open No. 2020-148512

[Summary of Invention]

[Technical Problem]

However, it is not easy to realize a light emitting device capable of generating a light pulse suitable for a LiDAR system from a viewpoint of the VCSEL and an electrical viewpoint for driving the VCSEL.
An object of the present invention is to provide a light emitting device including a semiconductor light emitting element capable of generating a light pulse having a short pulse width and a high peak value, and a ranging device using such a light emitting device.

[Solution to Problem]

According to an embodiment of the present disclosure, there is provided a light emitting device including a semiconductor light emitting element including a first reflector, a resonator spacer including an active layer, and a second reflector stacked in this order over a semiconductor substrate, wherein the semiconductor light emitting element includes a saturable absorption layer provided between the semiconductor substrate and the second reflector, and wherein the semiconductor light emitting element is configured to emit light having a profile that has a maximum peak value and converges to a stable value of a predetermined light intensity after the maximum peak value.
According to still another embodiment of the present specification, there is provided a light emitting device including a semiconductor light emitting element including a first reflector, a resonator spacer including an active layer, and a second reflector stacked in this order over a semiconductor substrate, wherein the semiconductor light emitting element includes a saturable absorption layer provided between the semiconductor substrate and the second reflector, and wherein the semiconductor light emitting element satisfies the following relationship: $\Gamma s \times gmax(Iop) > \Gamma a \times \alpha2 + \alpha m + \alpha i$ where $\Gamma s$ is an optical confinement coefficient of the active layer; $\Gamma a$ is an optical confinement coefficient of the saturable absorption layer; $gmax(Iop)$ is a maximum gain in the active layer obtained when a current value injected from a driving unit is $Iop$; $\alpha2$ is an absorption coefficient of the saturable absorption layer; $\alpha m$ is a mirror loss; and $\alpha i$ is a light absorption by carriers.
According to still another embodiment of the present specification, there is provided a light emitting device including a semiconductor light emitting element including a first reflector, a resonator spacer including an active layer, and a second reflector stacked in this order over a semiconductor substrate, wherein the active layer includes 6 to 50 quantum well layers, wherein the semiconductor light emitting element further includes a saturable absorption layer provided between the semiconductor substrate and the second reflector, and wherein an optical thickness of the resonator spacer is not less than a thickness corresponding to 5 times a resonance wavelength.

According to still another embodiment of the present specification, there is provided a light emitting device including a semiconductor light emitting element including a first reflector, a resonator spacer including an active layer, and a second reflector stacked in this order over a semiconductor substrate, wherein the semiconductor light emitting element includes a saturable absorption layer provided between the semiconductor substrate and the second reflector, and wherein the active layer includes a plurality of quantum well layers and a plurality of barrier layers provided between the plurality of quantum well layers, and wherein the barrier layers are formed of GaAs.

[Advantageous Effects of Invention]

According to the present invention, it is possible to realize a light emitting device including a semiconductor light emitting element capable of generating a light pulse having a short light pulse width and a high peak value, and a high-performance ranging device using such a light emitting device.

[Brief Description of Drawings]

[FIG. 1]

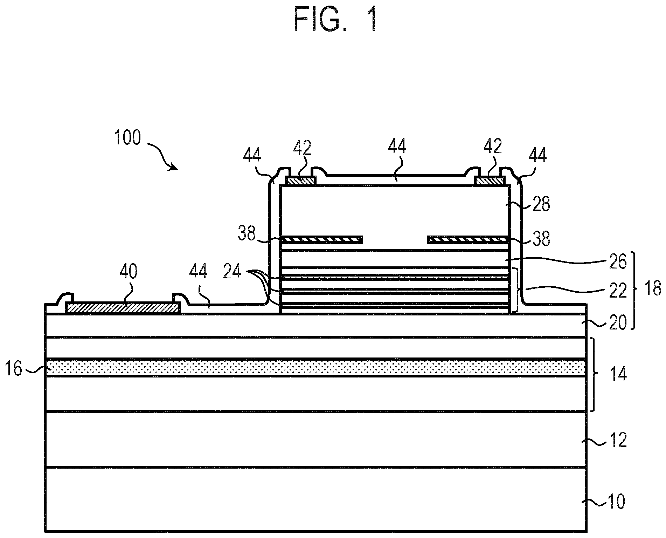

FIG. 1 is a schematic cross-sectional view illustrating a semiconductor light emitting element according to a first embodiment of the present invention.
[FIG. 2]

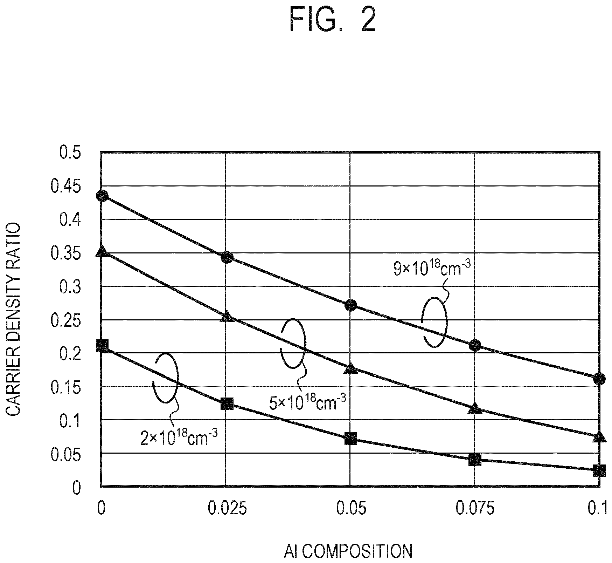

FIG. 2 is a graph illustrating an Al composition dependency of a ratio between a density of carriers accumulated in a well layer and a density of carriers accumulated in a barrier layer.
[FIG. 3]

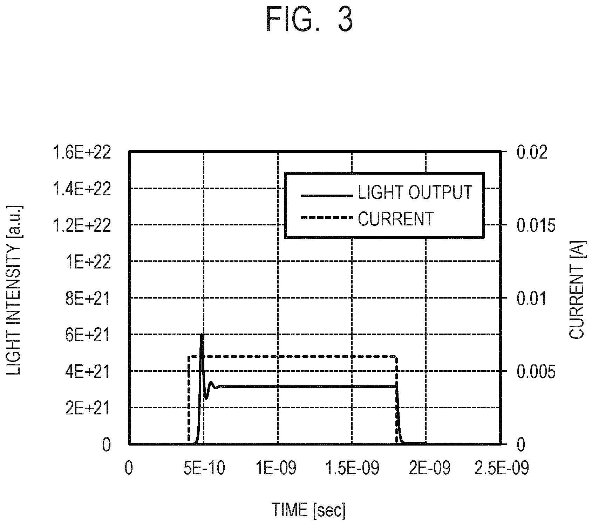

FIG. 3 is a graph illustrating a light output waveform of a semiconductor light emitting element according to a comparative example.
[FIG. 4]

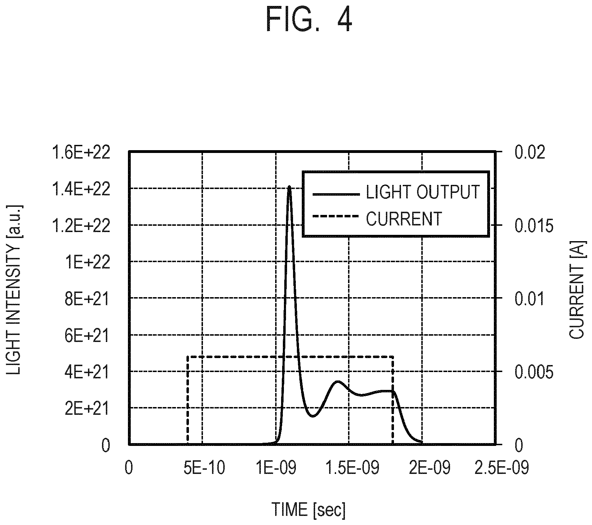

FIG. 4 is a graph illustrating a light output waveform of the semiconductor light emitting element according to the first embodiment of the present invention.
[FIG. 5]

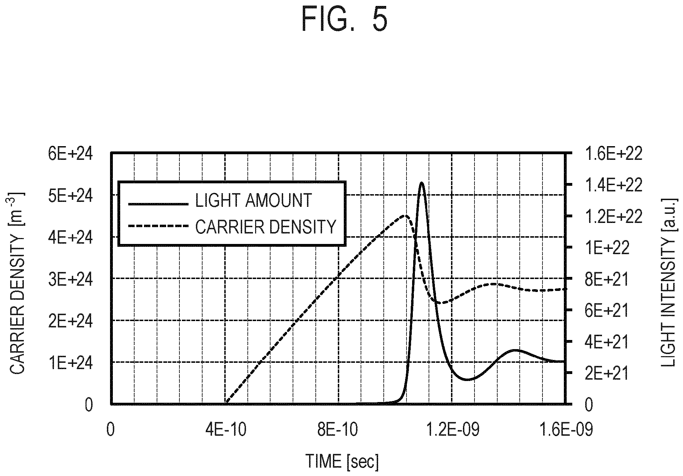

FIG. 5 is a graph illustrating temporal changes of a density of carriers accumulated in an active layer and a light intensity.
[FIG. 6]

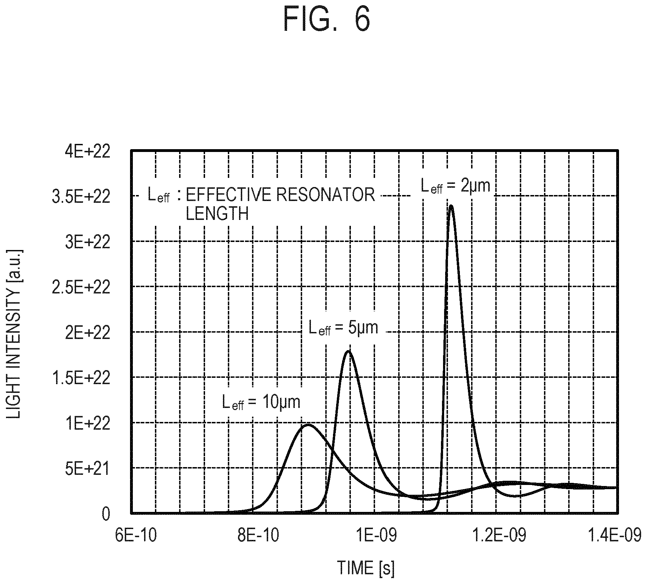

FIG. 6 is a graph illustrating a relationship between an effective resonator length and a light output waveform.
[FIG. 7]

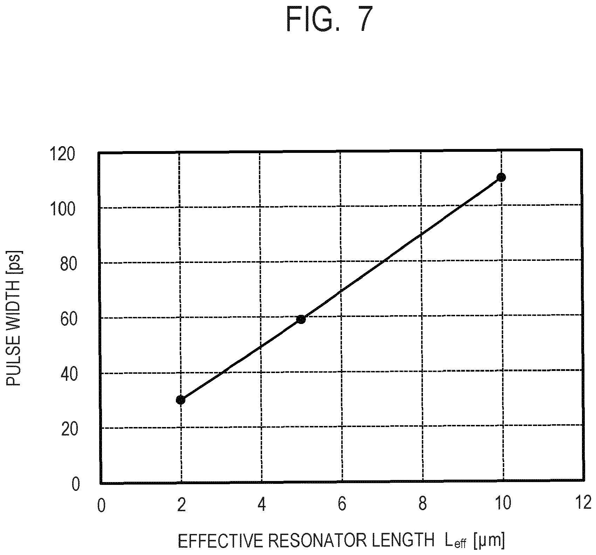

FIG. 7 is a graph illustrating a relationship between an effective resonator length and a pulse width of a light output.
[FIG. 8]

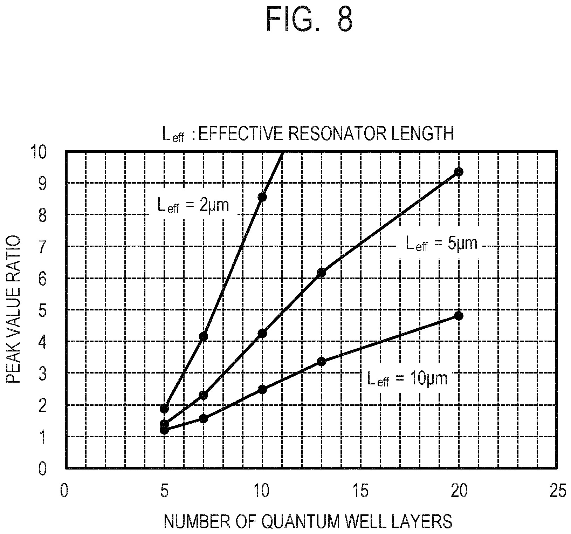

FIG. 8 is a graph illustrating a relationship between the number of the quantum well layers and a peak value ratio.
[FIG. 9]

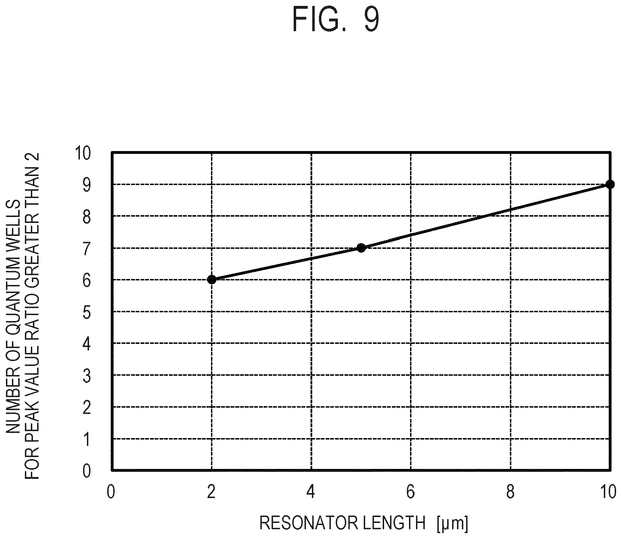

FIG. 9 is a graph illustrating a relationship between the minimum number of the quantum well layers necessary for a peak value ratio to exceed 2 and a resonator length.
[FIG. 10]

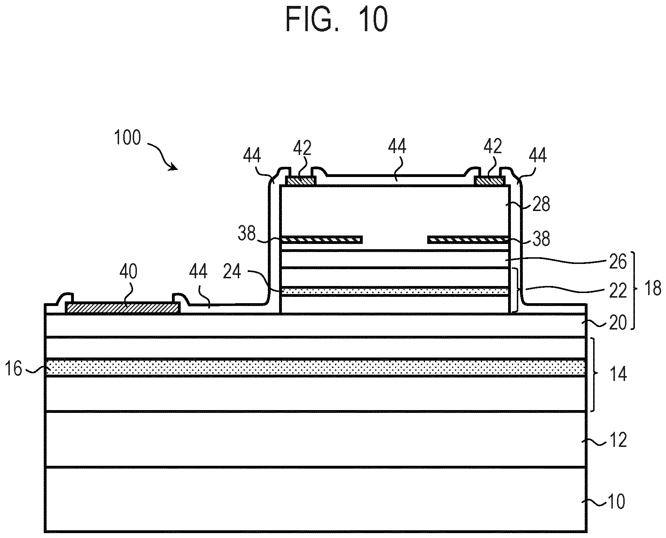

FIG. 10 is a schematic cross-sectional view illustrating a semiconductor light emitting element according to a second embodiment of the present invention.
[FIG. 11]

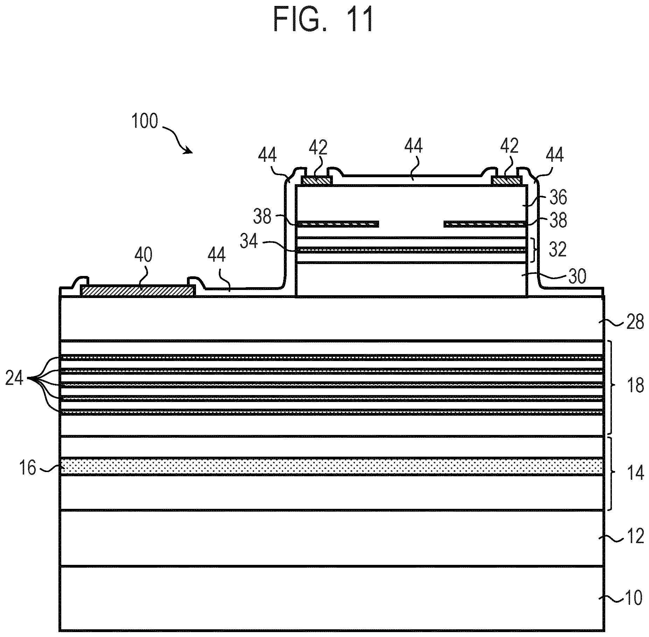

FIG. 11 is a schematic cross-sectional view illustrating a semiconductor light emitting element according to a third embodiment of the present invention.
[FIG. 12]

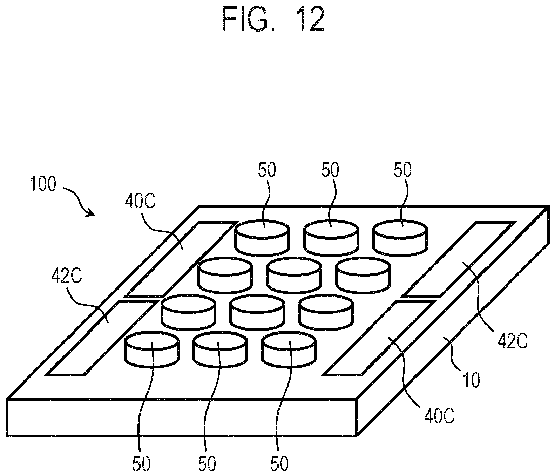

FIG. 12 is a perspective view illustrating a semiconductor light emitting element according to a fourth embodiment of the present invention.
[FIG. 13]

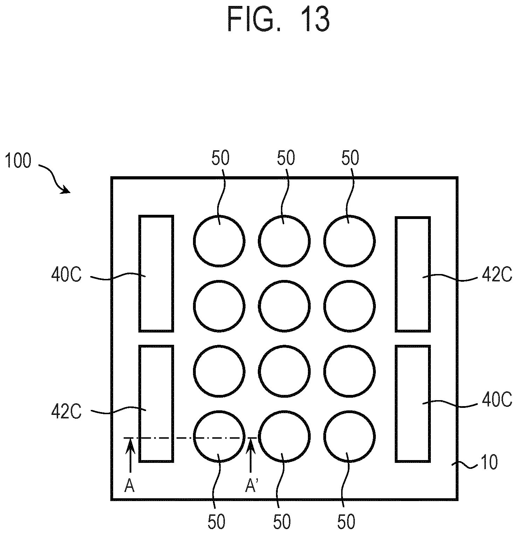

FIG. 13 is a top view of the semiconductor light emitting element according to the fourth embodiment of the present invention.
[FIG. 14]

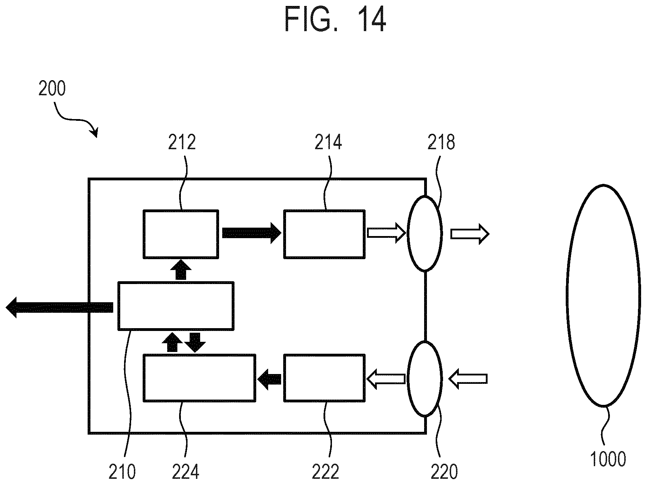

FIG. 14 is a block diagram illustrating a schematic configuration of a ranging device according to a fifth embodiment of the present invention.
[FIG. 15]

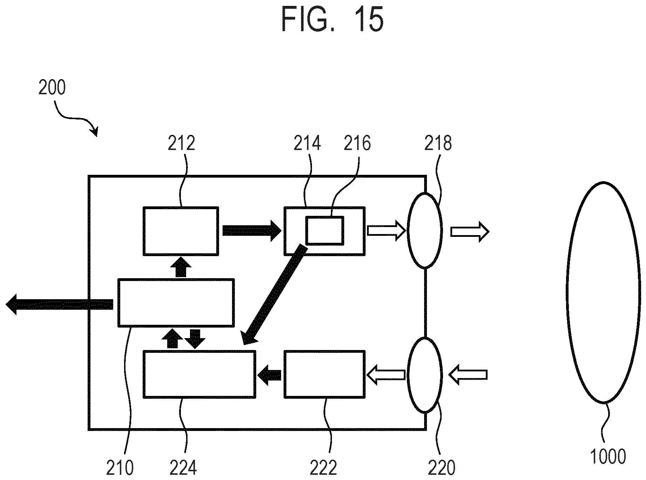

FIG. 15 is a block diagram illustrating a schematic configuration of a ranging device according to a sixth embodiment of the present invention.
[FIG. 16]

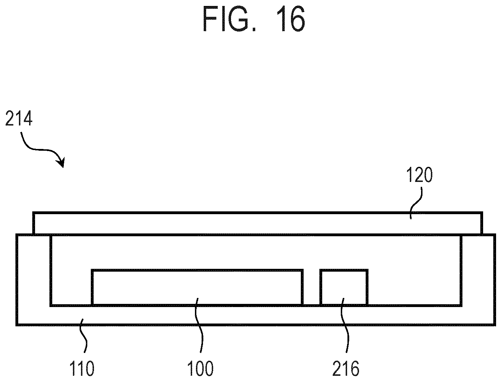

FIG. 16 is a schematic cross-sectional view illustrating a configuration example of a surface emitting laser array in the ranging device according to the sixth embodiment of the present invention.
[FIG. 17]

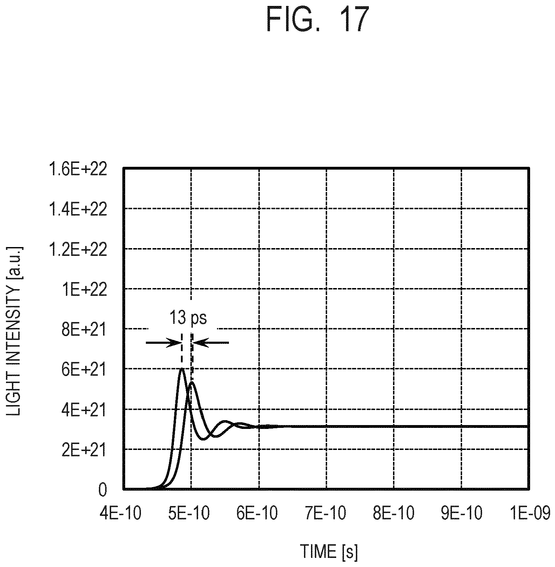

FIG. 17 is a graph illustrating a change in a light waveform due to a change in environmental temperature and a change in physical parameter over time in a semiconductor light emitting element according to a comparative example.
[FIG. 18]

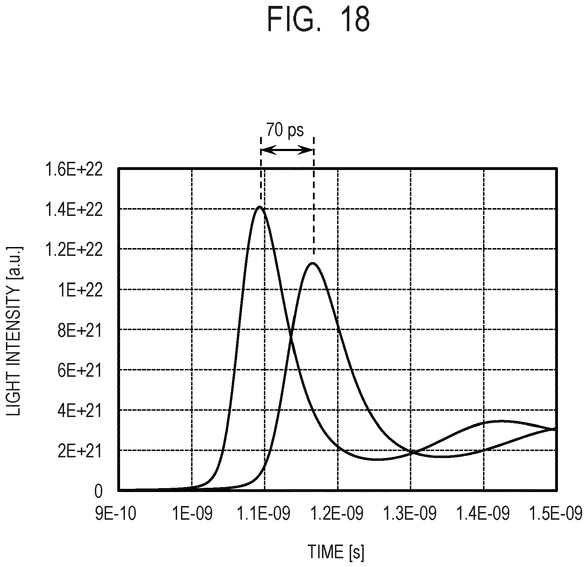

FIG. 18 is a graph illustrating a change in a light waveform due to a change in environmental temperature and a change in physical parameter over time in a semiconductor light emitting element according to the present invention.

[Description of Embodiments]

[First Embodiment]

A semiconductor light emitting element according to a first embodiment of the present invention will be described with reference to FIG. 1. FIG. 1 is a schematic cross-sectional view illustrating a structure of a semiconductor light emitting element according to the present embodiment.

The semiconductor light emitting element 100 according to the present embodiment is a VCSEL (Vertical Cavity Surface Emitting Laser) having a DBR (Distributed Bragg Reflector). As illustrated in FIG. 1, the semiconductor light emitting element 100 includes a semiconductor substrate 10, a lower DBR layer 12, a non-doped spacer 14, a resonator 18, an upper DBR layer 28, electrodes 40 and 42, and a protective film 44. The lower DBR layer 12 is provided over the semiconductor substrate 10. The non-doped spacer 14 is provided over the lower DBR layer 12. The resonator 18 is provided over the non-doped spacer 14. The upper DBR layer 28 is provided over the resonator 18. A layer located between the lower DBR layer 12 and the upper DBR layer 28 (non-doped spacer 14 and resonator 18) is a resonator spacer.

A saturable absorption layer 16 is provided in the non-doped spacer 14. The resonator 18 includes an n-type layer 20 provided over the non-doped spacer 14, a non-doped spacer 22 provided over the n-type layer 20, and a p-type layer 26 provided over the non-doped spacer 22. Three active layers 24 are provided in the non-doped spacer 22. An oxidized confinement layer 38 is provided in the upper DBR layer 28.

The non-doped spacer 22, the p-type layer 26, and the upper DBR layer 28 are processed into a mesa shape. An electrode 40 electrically connected to the n-type layer 20 is provided on the n-type layer 20 exposed by removing the non-doped spacer 22, the p-type layer 26, and the upper DBR layer 28 to form the mesa shape. An electrode 42 electrically connected to the upper DBR layer 28 is provided on the upper DBR layer 28. A protective film 44 is provided over the upper surface of the n-type layer 20 and the side and upper surfaces of the mesa except for at least a part of the surfaces of the electrodes 40 and 42.

The semiconductor substrate 10 may be, for example, a GaAs substrate. The lower DBR layer 12 may be formed, for example, by stacking 35 pairs of a stacked body of an $Al_{0.1}GaAs$ layer and an $Al_{0.9}GaAs$ layer each having an optical thickness of 1/4 $\lambda c$ as one pair. Here, $\lambda c$ is a center wavelength of a high reflection band of the lower DBR layer 12, and is 940 nm in the present embodiment.

The non-doped spacer 14 does not exist in a general VCSEL. The saturable absorption layer 16 may be formed of, for example, a multiple quantum well including three quantum wells each of which an InGaAs well layer having a thickness of 8 nm is sandwiched between AlGaAs barrier layers having a thickness of 10 nm. The other portions of the non-doped spacer 14 may be a non-doped GaAs layer.

The resonator 18 is formed of a p-i-n junction including an n-type layer 20, a non-doped spacer 22, and a p-type layer 26. Each of the three active layers 24 arranged in the non-doped spacer 22 may be formed of, for example, a multiple quantum well including four quantum wells each of which an InGaAs well layer having a thickness of 8 nm is sandwiched between AlGaAs barrier layers having a thickness of 10 nm. In this case, the resonator 18 includes a total of 12 quantum wells. The n-type layer 20, the p-type layer 26, and the other portions of the non-doped spacer 22 may be formed of an n-type GaAs layer, a p-type GaAs layer, and a non-doped GaAs layer, respectively.

As described above, the resonator 18 is formed of a p-i-n junction also existing in a normal VCSEL, and has a configuration similar to a resonator including an active layer in an i-layer. However, the number of the quantum well layers included in the resonator 18 is larger than the number of the quantum well layers included in the normal VCSEL (about three layers). The effective resonator length in the resonator 18 is 10 $\mu$m.

In the present embodiment, the three layers of the active layer 24 are arranged not at the antinode position of the standing wave used in the design of a general VCSEL but at a position between the antinode and the node of the standing wave. This makes it possible to optimize the response characteristics of light when the driving current is injected.

Further, the optical confinement coefficient for the standing wave is generally in the range of 1.5 to 2.0 in the normal VCSEL, but in the present embodiment, the optical confinement coefficient is intentionally set to be as low as about 0.35. Further, the AlGaAs barrier layer is designed to have a smaller band gap than the barrier layer in the quantum well of the normal VCSEL, whereby carriers are accumulated also in the barrier layer. Thus, the number of the InGaAs well layers in which carriers are accumulated is 12, but carriers are accumulated also in the AlGaAs barrier layer, whereby carriers corresponding to approximately 20 layers in the normal quantum well can be accumulated.

FIG. 2 is a graph illustrating a calculation result of an Al composition dependency of a ratio between the density of carriers accumulated in the InGaAs well layer and the density of carriers accumulated in the AlGaAs barrier layer. In FIG. 2, the plot of the symbol ■ indicates the case where the carrier density of the well layer is $2 \times 10^{18}$ cm$^{-3}$, the plot of the symbol A indicates the case where the carrier density of the well layer is $5 \times 10^{18}$ cm$^{-3}$, and the plot of the symbol • indicates the case where the carrier density of the well layer is $9 \times 10^{18}$ cm$^{-3}$.

The minimum carrier density for generating light amplification by stimulated emission necessary for laser oscillation is about $2 \times 10^{18}$ cm$^{-3}$. Therefore, assuming that the density of carriers accumulated in the quantum well is $2 \times 10^{18}$ cm$^{-3}$, the ratio between the density of carriers accumulated in the well layer and the density of carriers accumulated in the barrier layer is about 0.075 when the Al composition of the AlGaAs barrier layer is 0.05 as illustrated in FIG. 2. When the Al composition of the AlGaAs barrier layer increases from 0.05 to 0.1, the ratio of the density of carriers accumulated in the well layer to the density of carriers accumulated in the barrier layer decreases to about 0.025.

The rough estimate of the maximum thickness for achieving the effects as the barrier layer for accumulating carriers is 1 $\mu$m, which is a diffusion length of carriers. The active layer of the VCSEL is often formed of three quantum wells. Therefore, assuming that carriers of an amount equal to or greater than an amount of carriers accumulated in three quantum wells having a total thickness of about 25 nm are accumulated in the barrier layer having a thickness of 1 $\mu$m, a ratio of carrier density of 0.025 or more, which is the inverse of the ratio of thicknesses, is required. That is, it is understood from the calculation result of FIG. 2 that AlGaAs having an Al composition of 0.1 or less is preferable as the barrier layer.

An energy difference between a band gap of the AlGaAs barrier layer having an Al composition of 0.1 and an emission level of the InGaAs well layer having an emission wavelength of 940 nm is 230 meV. That is, the energy difference between the band gap of the barrier layer and the emission level of the well layer is preferably 230 meV or less. On the other hand, a lower limit of the energy difference between the band gap of the barrier layer and the emission level of the well layer is an energy corresponding to a difference from the band gap of GaAs from a viewpoint of light absorption. That is, in the case of oscillation at a wavelength of 940 nm, the energy difference between the band gap of the barrier layer and the emission level of the well layer is preferably 105 meV or more. From the above, the preferable range of the energy difference between the emission level of the well layer and the band gap of the barrier layer is 105 meV to 230 meV.

The upper DBR layer 28 may be formed, for example, by stacking 20 pairs of a stacked body of an $Al_{0.1}Ga_{0.9}As$ layer and an $Al_{0.9}Ga_{0.1}As$ layer each having an optical thickness of 1/4 $\lambda$c as one pair. In the upper DBR layer 28, the oxidized confinement layer 38 formed by oxidizing a part of an $Al_{0.98}Ga_{0.02}As$ layer having a thickness of 30 nm is provided. The oxidized confinement layer 38 may be formed, for example, by oxidizing the $Al_{0.98}Ga_{0.02}As$ layer from side surfaces of the mesa with water vapor during manufacturing. The oxidized confinement layer 38 has a non-oxidized portion in the central portion of the mesa and an oxidized portion in the vicinity of the sidewall of the mesa. A diameter of the non-oxidized portion in a plan view may be about 10 $\mu$m. Thus, since the current injected into the semiconductor light emitting element 100 flows only in the non-oxidized portion, a laser oscillation only occurs in a portion overlapping the center portion of the mesa of the semiconductor light emitting element 100 in the plan view.

The laser light generated in the semiconductor light emitting element 100 may be emitted from the upper DBR layer 28 side, or may be emitted from the semiconductor substrate 10 side.

As described above, in the semiconductor light emitting element 100 according to the present embodiment, the following three elements are further added based on the configuration of the normal VCSEL. One of the three factors added to the VCSEL is to substantially increase the volume of the active layer. For example, a normal VCSEL includes three quantum wells, but the number of the layers is increased to about 20 layers in terms of the volume of the quantum well. The second is to introduce the saturable absorption layer 16. The third is to extend the effective resonator length as the VCSEL. The effective resonator length is a resonator length in which light is sensed in the resonator. More specifically, it is an average value of a propagation distance of light that transmits through the active layer in the resonance direction, is reflected by two reflectors constituting the resonator, and transmits through the active layer again. By adding at least one of these elements, preferably three, it is possible to realize a VCSEL capable of generating a light pulse having a high peak value and a short pulse width.

Next, the operation of the semiconductor light emitting element 100 according to the present embodiment will be described with reference to FIG. 3 to FIG. 9.

FIG. 3 and FIG. 4 are graphs illustrating results obtained by calculation of light output waveforms of the semiconductor light emitting element. FIG. 3 is a light output waveform of a semiconductor light emitting element according to a comparative example, and FIG. 4 is a light output waveform of the semiconductor light emitting element 100 according to the present embodiment. The semiconductor light emitting element according to the comparative example is a VCSEL having a general structure in which a saturable absorption layer is not provided, three quantum wells are provided, and a resonator length is 1 λ.

In the case of a configuration of the general semiconductor light emitting element, as illustrated in FIG. 3, oscillation starts at about 70 ps from the start of current injection, and the light output rises. Then, the light output reaches a peak of a light waveform accompanying the relaxation vibration, and then converges to a steady value.

On the other hand, the semiconductor light emitting element 100 according to the present embodiment emits light having a maximum peak value and a profile that converges to a stable value that is a predetermined light intensity after the maximum peak value. That is, in the semiconductor light emitting element 100 according to the present embodiment, for example, as illustrated in FIG. 4, oscillation starts after about 600 ps has elapsed from the start of current injection. The lag in the start of oscillation is due to the fact that the effective volume of the active layer 24 is increased, and the fact that oscillation is inhibited by absorption of light in the saturable absorption layer 16 for a certain period of time from the start of current injection. When light is absorbed by the saturable absorption layer 16, the absorbed light is accumulated as carriers in the saturable absorption layer 16. When carriers increase with light absorption and the carrier density in the saturable absorption layer 16 reaches the transparent carrier density, the saturable absorption layer 16 does not absorb light. As a result, the effect of blocking the laser oscillation is eliminated, and the semiconductor light emitting element starts the laser oscillation.

The purpose of inhibiting laser oscillation by the saturable absorption layer 16 for a certain period of time is to accumulate carriers exceeding a threshold carrier density in the active layer 24. Here, the threshold carrier density is a carrier density for generating a gain necessary for laser oscillation.

FIG. 5 is a graph illustrating temporal changes in the density of carriers accumulated in the active layer 24 and the light intensity. The current injected into the semiconductor light emitting element has a waveform similar to that of FIG. 4, and the injection is started from a time point of 4E-10 seconds on the time axis.

As illustrated in FIG. 5, the carrier density of the active layer 24 begins to increase with the start of current injection. In the semiconductor light emitting element 100 according to the present embodiment, the threshold carrier density (carrier density converged after the start of oscillation) is $2.7E18$ cm$^{-3}$, but in a state before the start of the laser oscillation, carriers continue to accumulate temporarily beyond the threshold carrier density. Thereafter, when laser oscillation starts, carriers are rapidly consumed by stimulated emission and the carrier density converges to a stable value.

Thus, in the semiconductor light emitting element 100 according to the present embodiment, more carriers are accumulated in the active layer 24 beyond the threshold carrier density. Then, carriers accumulated in the active layer 24 after the start of laser oscillation are converted into photons by stimulated emission. This makes it possible to output a light pulse having a high peak value and a short half width as illustrated in FIG. 4.

The reason why carriers having a carrier density not less than the threshold carrier density can be accumulated in the active layer 24 is that laser oscillation is suppressed for a certain period of time by using the saturable absorption layer 16. By realizing such a high carrier density, a light pulse having a high peak value and a short pulse width can be generated inside the semiconductor light emitting element after oscillation. This light pulse is shorter than the current pulse for driving the semiconductor light emitting element.

After the generation of the light pulse, the laser oscillation continues as illustrated in FIG. 5. Here, the condition under which the laser oscillation continues is that the maximum gain obtained by the active layer 24 exceeds absorption in the entire resonator. Specifically, laser oscillation is continued when the relationship represented by the following expression (1) is satisfied. In the expression (1), Γa is an optical confinement coefficient of the saturable absorption layer 16, Γs is an optical confinement coefficient of the active layer 24, and gmax(Iop) is a maximum gain in the active layer 24 obtained when the current value is Iop. Further, α2 denotes an absorption coefficient of the saturable absorption layer 16, αm denotes a mirror loss, and αi denotes a light absorption by carriers, etc. in the semiconductor.

$$\Gamma s \times gmax(Iop) > \Gamma a \times \alpha 2 + \alpha m + \alpha i \quad \dots (1)$$

In consideration of application of the semiconductor light emitting element 100 according to the present embodiment to LiDAR or the like, it is preferable to keep oscillation in a stable state after generation of a pulsed light. This is because the number of current pulses output from the driving unit of the semiconductor light emitting element and the number of the pulsed light generated in the semiconductor light emitting element are the same. On the contrary, when a plurality of pulsed light is generated from the semiconductor light emitting element when a constant current is continuously injected during a specific period, it is difficult to separate the leading pulsed light and the subsequent pulsed light from each other when viewed from the light receiving side, and there is a possibility that an error becomes large in calculating the distance. Further, from the viewpoint of eye safety, there is a possibility that a demerit such as a decrease in the amount of light allowed for one pulsed light may occur.

In the present embodiment, the non-doped spacer 14 is used to extend the distance from the lower DBR layer 12 to the upper DBR layer 28, thereby extending the resonator length as a laser. The purpose is to widen the pulse width. The optical thickness of the resonator spacer is preferably not less than a thickness corresponding to 5 times the resonance wavelength, more preferably not less than a thickness corresponding to 11 times the resonance wavelength. The optical thickness is a value obtained by multiplying the physical thickness by the refractive index of the medium.

FIG. 6 is a graph illustrating results obtained by calculation of light output waveforms when rectangular current pulses are injected into the semiconductor light emitting elements having effective resonator lengths Leff of 2 $\mu$m, 5 $\mu$m, and 10 $\mu$m. FIG. 7 is a graph illustrating a relationship between an effective resonator length and a pulse width of light output. As illustrated in FIG. 6 and FIG. 7, the pulse width of the light output may be increased by increasing the effective resonator length. In the case of the configuration of the present embodiment in which the active layer 24 is equivalent to 20-number of the quantum well layers and the saturable absorption layer 16 is equivalent to 3-number of the quantum well layers, the pulse width was 30 ps when the effective resonator length was 2 $\mu$m, the pulse width was 59 ps when the effective resonator length was 5 $\mu$m, and the pulse width was 110 ps when the effective resonator length was 10 $\mu$m. Here, the pulse width is a half width.

When an error of the light receiving timing on the light receiving element side is, for example, 100 ps, it is preferable to narrow the pulse width on the light emitting element side to the same level, but even if the pulse width is further narrowed to, for example, 10 ps, the advantages are small. Therefore, when the pulse width required for the light emitting element side is about 50 ps or more, the effective resonator length is preferably 4 $\mu$m or more. When the pulse width obtained from the error of the light reception timing is 30 ps, the effective resonator length is preferably 2 $\mu$m or more.

In the present embodiment, the effective resonator length is extended by increasing the layer thickness of the non-doped spacer 14 or the like to increase the physical distance between the lower DBR layer 12 and the upper DBR layer 28, but the method of extending the effective resonator length is not limited thereto. For example, by providing a third reflector between the lower DBR layer 12 and the upper DBR layer 28 to form a coupled resonator, the resonator length can be effectively extended even when the distance between the lower DBR layer 12 and the upper DBR layer 28 is shorter than in the present embodiment. In any case, by appropriately controlling the effective resonator length, the pulsed light width can be controlled to a preferable width.

Next, the thickness of the active layer 24, more specifically, the necessary range of the number of the quantum well layers constituting the active layer 24 will be described.

FIG. 8 is a graph illustrating the relationship between the number of the quantum well layers and the peak value ratio in the semiconductor light emitting elements having effective resonator lengths Leff of 2 $\mu$m, 5 $\mu$m, and 10 $\mu$m. The peak value ratio is a ratio between a peak value of the light pulse waveform and a steady value after stabilization. For example, the peak value ratio of 2 means that the amount of light of the peak value is twice the amount of light of the steady value.

As illustrated in FIG. 8, the peak value ratio increases as the number of the quantum well layers increases. When comparison is made at the same peak value ratio, the number of the quantum well layers required increases as the effective resonator length increases.

FIG. 9 is a graph illustrating the relationship between the minimum number of the quantum well layers necessary for the peak value ratio to exceed 2 and the resonator length.

As illustrated in FIG. 9, when the resonator length is 2 $\mu$m, the number of the quantum well layers having a peak value ratio of more than 2 is 6 or more. When the resonator length is 5 $\mu$m, the number of the quantum well layers having a peak value ratio of more than 2 is 7 or more. When the resonator length is 10 $\mu$m, the number of the quantum well layers having a peak value ratio of more than 2 is 9 or more. In the semiconductor light emitting element having a resonator length of 2 $\mu$m or more, when the design criterion of the peak value ratio is assumed to be 2 or more, the number of the quantum well layers required is 6 or more. From the viewpoint of the pulse width described above, the resonator length is preferably not less than 4 $\mu$m, and in this case, the required number of the quantum well layers is not less than 7.

Here, the number of the quantum well layers is obtained by converting the thickness of a portion where carriers are accumulated into the number of the quantum well layers, and does not necessarily have to coincide with the actual number of the quantum well layers. That is, the actual number of the quantum well layers may be designed according to the relationship illustrated in FIG. 8 and FIG. 9. Alternatively, it may be designed such that carriers are accumulated also in the layers around the quantum well layers, although the actual number of the quantum well layers is smaller than the total number according to the relationships illustrated in FIG. 8 and FIG. 9, and substantially desired carriers may be accumulated.

As is apparent from FIG. 6 to FIG. 9, from the viewpoint of the pulse width and the peak value ratio, the number of the quantum well layers is preferably as large as possible, and there is no particular upper limit. However, when carriers are injected into the i-layer of the p-i-n junction by current injection, the thickness of the i-layer is limited by the degree of carrier diffusion from the p-layer and the n-layer. The diffusion distance largely varies depending on the material and composition of the active layer 24, and when the diffusion distance is 1 $\mu$m, the number of the quantum well layers is about 50. The number of the quantum well layers constituting the active layer 24 is preferably appropriately selected from the range of, for example, 6 layers or more and 50 layers or less.

Next, an example of a method of manufacturing the semiconductor light emitting element 100 according to the present embodiment will be described below.

First, semiconductor layers constituting the lower DBR layer 12, the non-doped spacer 14, the resonator 18, and the upper DBR layer 28 are grown over the semiconductor substrate 10 by a metalorganic vapor phase epitaxy method or a molecular beam epitaxy method.

Next, the upper DBR layer 28, the p-type layer 26, and the non-doped spacer 22 are patterned by photolithography and etching. Thus, a columnar mesa having a diameter of, e.g., about 30 $\mu$m is formed.

Then, thermal oxidation is performed in a water vapor atmosphere at about 450 °C to oxidize the $Al_{0.98}Ga_{0.02}As$ layer in the upper DBR layer 28 from the sidewall of the mesa to form the oxidized confinement layer 38. At this time, by controlling the oxidation time, a non-oxidized portion in the central portion of the mesa and an oxidized portion (oxidized confinement layer 38) in the vicinity of the sidewall of the mesa are formed in the $Al_{0.98}Ga_{0.02}As$ layer. The non-oxidized portion of the $Al_{0.98}Ga_{0.02}As$ layer is controlled to have a diameter of about 10 $\mu$m.

Next, the electrode 42 serving as a p-side electrode is formed on the upper surface of the mesa by photolithography and vacuum evaporation, and the electrode 40 serving as an n-side electrode is formed on the upper surface of the n-type layer 20 exposed by etching. The electrode 42 has an annular pattern, and a central opening becomes a circular window for light extraction.

Next, a protective film 44 is formed by photolithography and plasma CVD (Chemical Vapor Deposition) method to cover the upper surface and the side surface of the mesa provided with the electrodes 40 and 42 and the upper surface of the n-type layer 20.

Next, in order to obtain good electric characteristics, heat treatment is performed in a nitrogen atmosphere to alloy the interface between the electrode material and the semiconductor material, thereby completing the semiconductor light emitting element 100 according to the present embodiment.

As described above, according to the present embodiment, it is possible to realize a semiconductor light emitting element and a light emitting device capable of generating a light pulse having a short light pulse width and a high peak value.

[Second Embodiment]

A semiconductor light emitting element according to a second embodiment of the present invention will be described with reference to FIG. 10. FIG. 10 is a schematic cross-sectional view illustrating the structure of the semiconductor light emitting element according to the present embodiment. Components similar to those of the semiconductor light emitting element according to the first embodiment are denoted by the same reference numerals, and description thereof will be omitted or simplified.

The semiconductor light emitting element according to the present embodiment is the same as the semiconductor light emitting element according to the first embodiment except that the structure of the resonator 18 is different from that of the semiconductor light emitting element according to the first embodiment. In the present embodiment, portions different from those of the semiconductor light emitting element according to the first embodiment will be mainly described, and a description of portions common to those of the semiconductor light emitting element according to the first embodiment will be appropriately omitted.

As illustrated in FIG. 10, the resonator 18 of the present embodiment is configured by a p-i-n junction including an n-type layer 20, a non-doped spacer 22, and a p-type layer 26, and is similar to the first embodiment in that an active layer 24 is provided in the non-doped spacer 22. The n-type layer 20 is a semiconductor layer having a high impurity concentration disposed between the active layer 24 and the saturable absorption layer 16.

The resonator 18 of the first embodiment has three active layers 24 each including three quantum wells in the non-doped spacer 22. On the other hand, the resonator 18 of the present embodiment includes one active layer 24 including four quantum wells in the non-doped spacer 22. The active layer 24 may be formed of, for example, a multiple quantum well including four quantum wells in which an InGaAs well layer having a thickness of 8 nm is sandwiched between GaAs barrier layers having a thickness of 10 nm. The other portions of the non-doped spacer 22 is formed of a non-doped GaAs layer.

As described above, the resonator 18 of the first embodiment includes the active layer 24 including a total of 12 quantum well layers, whereas the resonator 18 of the present embodiment includes the active layer 24 including four quantum well layers. The reason why the total number of the quantum well layers included in the active layer 24 of the resonator 18 of the present embodiment can be reduced to four is that portions of the non-doped spacer 22 other than the InGaAs well layer including barrier layers are made of GaAs instead of AlGaAs.

By forming the portions of the non-doped spacer 22 other than the InGaAs well layer of GaAs, the band gap of the barrier layers can be made smaller than that in the case of using AlGaAs as the barrier layers. As a result, since carriers can be accumulated in GaAs, the amount of carriers necessary for achieving the effect of the invention according to the present embodiment can be easily increased. As a result of eliminating the need to increase the number of quantum well layers, the number of the quantum well layers can be reduced from 12 to 4.

In the semiconductor light emitting element according to the first embodiment, the optical confinement coefficient for the standing wave is as low as about 0.35. On the other hand, in the semiconductor light emitting element according to the present embodiment, since the number of the quantum well layers is reduced, the optical confinement coefficient is set to about 1.4. In other words, the quantum well layer is disposed near the antinode position of the standing wave. This is because the product of the number of the quantum well layers and the optical confinement coefficient is the gain of the laser resonator, and the first embodiment and the present embodiment are configured to obtain the same gain. By setting the product of the number of the quantum well layers and the optical confinement coefficient to be approximately the same, the relaxation oscillation frequency, that is, the pulse width at the time of pulse generation can be set to be approximately the same.

The configuration of the present embodiment in which carriers are actively accumulated in the barrier layers has a secondary effect in addition to the above-described effect. Two secondary effects will be described below as an example.

The first effect is that the cumulative strain of the semiconductor layers can be reduced. Assuming that the oscillation wavelength is set to 940 nm, since the active layer is InGaAs and the substrate is GaAs, strain due to a difference in lattice constant occurs in the active layer grown over the substrate. The cumulative strain increases as the number of the quantum well layers increases. Therefore, the design of reducing the number of the quantum well layers by reducing the band gap of the barrier layers as in the present embodiment has an effect of reducing the cumulative strain. This is not a unique effect obtained when the oscillation wavelength is 940 nm, but a common effect obtained when the lattice constant of the constituent material of the substrate is different from the lattice constant of the constituent material of the layer grown thereover such as the active layer.

The second effect is that carrier consumption due to radiative recombination can be reduced. In all semiconductors including quantum well layers and barrier layers, carriers are consumed by radiative recombination (spontaneous emission) when both holes and electrons are present at the same time. In the case of a semiconductor laser, when the consumption of carriers due to radiative recombination (spontaneous emission) increases, the threshold value of laser oscillation increases and the power conversion efficiency decreases, which is not preferable. It is known that this radiative recombination is proportional to the square of the carrier density. Therefore, even when the same amount of carriers are accumulated, the carrier density, that is, the amount of carriers consumed by the radiative recombination also changes depending on the volume of the portion where the carriers are accumulated.

When carriers are accumulated by increasing the total number of the quantum well layers as in the first embodiment, the carrier density of the quantum well layer increases because the band gap is small. In this case, although there is an advantage that the total thickness of the layers is reduced, carriers consumed by the radiative recombination also increase because the carrier density increases. On the other hand, when carriers are accumulated in a layer having a band gap larger than that of the quantum well layer as in the present embodiment, the carrier density becomes low because the band gap is large, and the total layer thickness of the layer accumulating carriers becomes large. However, since the carrier density is low, consumption of carriers due to the radiative recombination is reduced. As described above, according to the present embodiment, since carriers are accumulated in a larger proportion in a layer having a band gap larger than that of the quantum well layer, consumption of carriers due to the radiative recombination can be reduced.

The n-type layer 20 is formed of a stacked structure of an $Al_{0.9}GaAs$ layer and a GaAsP layer. Specifically, an $Al_{0.9}GaAs$ layer is provided between the GaAsP layer and the non-doped spacer 22. The Al composition of the AlGaAs layer is increased to 0.9 in order to increase the band gap and prevent carriers overflowing from the active layer 24 from flowing into the saturable absorption layer 16. Therefore, the $Al_{0.9}GaAs$ layer is provided near the non-doped spacer 22. On the other hand, the GaAsP layer serves as a strain compensation layer. In the present embodiment, the number of the quantum well layers is smaller than that in the first embodiment, but because an InGaAs layer is used for the quantum well layer, cumulative strain occurs. Therefore, the accumulated strain is reduced by inserting the GaAsP layer that generates lattice strain in a direction opposite to that of InGaAs with respect to GaAs.

The AlGaAs layer constituting the n-type layer 20 has an effect of suppressing carrier overflow even when the Al composition is 0.9 or less. In the case of the AlGaAs-based material, the increase amount of the band gap with respect to the increase of the Al composition decreases from the Al composition of around 0.45. In other words, the amount of decrease in the band gap caused by lowering the Al composition of the AlGaAs layer from 0.9 to 0.45 is small. On the other hand, when the Al composition of the AlGaAs layer exceeds 0.9, the formation speed of the native oxide film is rapidly increased by the reaction with oxygen in the air, which is not preferable from the viewpoint of the manufacturing process and the reliability of the element. From this viewpoint, the Al composition of the AlGaAs layer constituting the n-type layer 20 is preferably 0.45 or more and 0.9 or less.

The design in which the energy difference between the emission level of the quantum well and the band gap of the barrier layer is reduced to such an extent that light absorption at the laser oscillation wavelength does not occur, and the design in which the thickness of the barrier layer is increased to increase the amount of carrier accumulation are opposite to the design idea of a normal semiconductor laser. The reason for this is that in the normal semiconductor laser, it is preferable that the light output responds as fast as possible to increase or decrease of the input current. In a semiconductor laser, carriers are accumulated only in a light emitting layer such as a quantum well, and the thickness of a barrier layer in which carriers move is made as thin as possible, thereby enabling a response at a higher speed.

In many applications including an optical communication and a LiDAR using ToF system, the amount of light is controlled by increasing or decreasing the current, and it is a major advantage that the light output increases or decreases following the current waveform that changes at high speed. For example, in the optical communication, the communication speed can be increased. Further, in the LiDAR using ToF system, by shortening the time width of the emitting light pulse, the accuracy of estimating the time during which the light detected by the light receiving side is generated on the light emitting side can be increased, and the distance measurement accuracy can be improved. Therefore, the design of increasing the number of the quantum well layers to the number necessary for oscillation or more and the design of increasing the carrier accumulation amount of the barrier layer are designed to be avoided because the followability of the increase/decrease of light to the current waveform becomes poor.

On the other hand, since the present invention is based on the idea of emitting a short pulse in the VCSEL, the light output does not necessarily need to follow the current waveform. The peak value of the pulse is preferably larger. Therefore, in the present embodiment, in the configuration including the saturable absorption layer 16 necessary for emitting a short pulse in the VCSEL, by designing to accumulate more carriers including the barrier layer, generation of a light pulse having a short pulse width and a high peak value is realized.

As described above, according to the present embodiment, it is possible to realize a semiconductor light emitting element and a light emitting device capable of generating a light pulse having a short light pulse width and a high peak value.

[Third Embodiment]

A semiconductor light emitting element according to a third embodiment of the present invention will be described with reference to FIG. 11. FIG. 11 is a schematic cross-sectional view illustrating the structure of the semiconductor light emitting element according to the present embodiment. Components similar to those of the semiconductor light emitting element according to the first or second embodiment are denoted by the same reference numerals, and description thereof will be omitted or simplified.

As illustrated in FIG. 11, the semiconductor light emitting element 100 includes a semiconductor substrate 10, a lower DBR layer 12, a non-doped spacer 14, a resonator 18, and an upper DBR layer 28. The semiconductor light emitting element 100 further includes a lower DBR layer 30, a resonator 32, an upper DBR layer 36, electrodes 40 and 42, and a protective film 44. The lower DBR layer 12 is provided over the semiconductor substrate 10. The non-doped spacer 14 is provided over the lower DBR layer 12. The resonator 18 is provided over the non-doped spacer 14. The upper DBR layer 28 is provided over the resonator 18. The lower DBR layer 30 is provided over the upper DBR layer 28. The resonator 32 is provided over the lower DBR layer 30. The upper DBR layer 36 is provided over the resonator 32.

The stacked structure of the lower DBR layer 12, the non-doped spacer 14, the resonator 18, and the upper DBR layer 28 constitutes a first VCSEL. The stacked structure of the lower DBR layer 30, the resonator 32, and the upper DBR layer 36 constitutes a second VCSEL. That is, in the semiconductor light emitting element 100 according to the present embodiment, the first VCSEL and the second VCSEL are stacked in this order over the semiconductor substrate 10.

The stacked structure of the first VCSEL is similar to that of the semiconductor light emitting element 100 according to the first embodiment. A saturable absorption layer 16 is provided in the non-doped spacer 14. Five active layers 24 are provided in the resonator 18. Each of the active layers 24 is formed of a multiple quantum well including four quantum wells. That is, the resonator 18 includes 20 quantum well layers in total. As in the first embodiment, the resonator 18 is designed to have a smaller band gap of the AlGaAs barrier layers than the barrier layers used in the quantum well of the normal VCSEL, and to accumulate carriers also in the AlGaAs barrier layers. Similar to the semiconductor light emitting element according to the first embodiment, the first VCSEL has a saturable absorption layer 16 and generates a light pulse of high peak value and short pulse. The structure of the semiconductor light emitting element according to the second embodiment may be applied to the first VCSEL.

The stacked structure of the lower DBR layer 30, the resonator 32, and the upper DBR layer 36 is processed into a mesa shape. The second VCSEL is formed in the mesa. An active layer 34 is provided in the resonator 32. An oxidized confinement layer 38 is provided in the upper DBR layer 36. An electrode 40 electrically connected to the upper DBR layer 28 and the lower DBR layer 30 is provided on the upper DBR layer 28 exposed by processing the lower DBR layer 30, the resonator 32, and the upper DBR layer 36 into the mesa shape. An electrode 42 electrically connected to the upper DBR layer 36 is provided on the upper DBR layer 36. A protective film 44 is provided on the upper surface of the upper DBR layer 28 and the side and upper surfaces of the mesa except at least a part of the surfaces of the electrodes 40 and 42.

The second VCSEL oscillates by applying a voltage between the electrode 40 and the electrode 42 and causing a current to flow, thereby generating laser light. The wavelength of the laser light generated by the second VCSEL is light having a wavelength shorter than the emission wavelength of the first VCSEL, for example, a wavelength of 780 nm. The laser light generated by the second VCSEL is excitation light for exciting the active layer 24 of the first VCSEL. By exciting the active layer 24 by the laser light generated in the second VCSEL, the first VCSEL generates a light pulse of high peak value and short pulse by a mechanism similar to that of the semiconductor light emitting element 100 according to the first embodiment.

The reason why the second VCSEL is provided over the first VCSEL in the semiconductor light emitting element 100 according to the present embodiment is to increase the number of the active layers 24 in the first VCSEL. In the case of the structure in which the p-i-n junction is formed as in the first embodiment, the thickness of the i-layer is limited by the diffusion length of carriers, in particular, the diffusion length of holes. On the other hand, when the active layer 24 is excited by irradiating the active layer 24 with light from the outside as in the present embodiment, there is no restriction on the carrier diffusion length, and thus there is an advantage that a VCSEL having more active layers 24 can be formed, and pulse energy can be increased.

As described above, according to the present embodiment, it is possible to realize a semiconductor light emitting element and a light emitting device capable of generating a light pulse having a short light pulse width and a high peak value.

[Fourth Embodiment]

A semiconductor light emitting element according to a fourth embodiment of the present invention will be described with reference to FIG. 12 and FIG. 13. FIG. 12 is a perspective view illustrating the semiconductor light emitting element according to the present embodiment. FIG. 13 is a top view of the semiconductor light emitting element according to the present embodiment.

The semiconductor light emitting element 100 according to the present embodiment is a light emitting device in which a plurality of light emitting portions 50 of the semiconductor light emitting element 100 according to the first to third embodiments are arranged in a two-dimensional array, that is, a so-called VCSEL array. A cross section taken along the line A-A' of FIG. 13 generally corresponds to the cross section of FIG. 1, FIG. 10, or FIG. 11. Each of the light emitting portions 50 in FIG. 12 corresponds to the mesa in FIG. 1, FIG. 10, or FIG. 11. The semiconductor substrate 10 in FIG. 12 corresponds to the n-type layer 20 from the semiconductor substrate 10 in FIG. 1 or FIG. 10, or the upper DBR layer 28 from the semiconductor substrate 10 in FIG. 11.

FIG. 12 and FIG. 13 illustrate only twelve light emitting portions 50 arranged in a 4 × 3 array for simplification of the drawing, but in a general VCSEL array, for example, 3600 VCSELs arranged in a 60×60 array are provided on the same semiconductor substrate 10. The diameter of the light emitting portion 50 is, for example, 10 μm. The light emitting portions 50 are arranged such that the distance between the centers of the light emitting portions 50 in the vertical direction and the horizontal direction in a plan view is, for example, 50 μm. The chip size of the semiconductor light emitting element 100 is, for example, 3.3 mm × 3.3 mm.

The electrode 40 corresponding to each of the light emitting portions 50 is electrically connected to the anode common electrode 40C via an interconnection (not illustrated). The electrodes 42 corresponding to the respective light emitting portions 50 are electrically connected to the cathode common electrode 42C. The anode common electrode 40C and the cathode common electrode 42C are electrodes common to the plurality of light emitting portions 50 constituting the VCSEL array. An Au wire (not illustrated) is electrically and physically connected to the anode common electrode 40C and the cathode common electrode 42C. A current for driving the semiconductor light emitting element 100 is injected from an external circuit via the anode common electrode 40C and the cathode common electrode 42C. The anode common electrode 40C and the cathode common electrode 42C have a strip-like shape with a width of, for example, 100 μm and a length of, for example, 1.5 mm.

As described above, according to the present embodiment, a VCSEL array using the semiconductor light emitting element 100 according to the first to third embodiments can be realized.

[Fifth Embodiment]

A ranging device according to a fifth embodiment of the present invention will be described with reference to FIG. 14. FIG. 14 is a block diagram illustrating a schematic configuration of the ranging device according to the present embodiment.

The ranging device 200 according to the present embodiment is a ranging device (LiDAR device) in which the semiconductor light emitting element 100 according to the fourth embodiment is applied to a light source unit.

The ranging device 200 according to the present embodiment may include a control unit 210, a surface emitting laser array driver 212, a surface emitting laser array 214, a light-emitting side optical system 218, a light-receiving side optical system 220, an image sensor 222, and a distance data processing unit 224.

The surface emitting laser array 214 is obtained by mounting the semiconductor light emitting element 100 according to the fourth embodiment on a package. The surface emitting laser array driver 212 is a driving unit that receives a driving signal from the control unit 210, generates a driving current for oscillating the surface emitting laser array 214, and outputs the driving current to the surface emitting laser array 214. The surface emitting laser array 214 and the surface emitting laser array driver 212 may be a single light emitting device.

The light-emitting side optical system 218 is an optical system that emits the laser light generated by the surface emitting laser array 214 toward the range to be measured. The light-receiving side optical system 220 is an optical system that guides the laser light reflected by the object to be measured 1000 to the image sensor 222. Although the light-emitting side optical system 218 and the light-receiving side optical system 220 are represented by a single convex lens-shaped member in FIG. 14, they are not formed of a single convex lens-shaped member, but are formed of a lens group in which a plurality of lenses is combined.

The image sensor 222 is a photoelectric conversion device in which a plurality of pixels each including a photoelectric conversion unit is arranged in a two-dimensional array, and is a light receiving device that outputs an electric signal corresponding to incident light. The image sensor 222 may be an imaging device such as a CMOS image sensor. The distance data processing unit 224 has a function as a distance information acquisition unit that generates information on a distance to the object to be measured 1000 existing in the range to be measured based on a signal from the image sensor 222 and outputs the information. The distance data processing unit 224 may be electrically connected to the image sensor 222, and may be disposed in the same package as the image sensor 222 or may be disposed in a package different from the image sensor 222.

The control unit 210 is formed of, e.g., an information processing device including a microcomputer, a logic circuit, and the like, and functions as a central processing unit that controls the operations in the ranging device 200 such as operation control of each unit and various calculation processes.

As described above, as a light emitting device suitable for a LiDAR system, a light emitting device capable of generating a light pulse having a short light pulse width and a high peak value is desirable. Specifically, the light pulse width of the light source suitable for the LiDAR system is, for example, in the range of about 50 ps to 1 ns. On the other hand, from a viewpoint of the VCSEL and an electrical viewpoint for driving the VCSEL, it is not easy to emit light with such a short pulse width. Since the VCSEL emits light according to the amount of injected current, it is necessary to equalize the current pulse for driving the VCSEL in order to set the light pulse to about 50 ps to 1 ns. That is, from the driver unit to the VCSEL, it is necessary to have an electric characteristic excellent in a high frequency band such as 1 GHz or 10 GHz as a frequency component and to handle a current exceeding 1 A. In this case, there is a problem in that the cost is increased as compared with a case where an electric transmission unit up to the driver or the VCSEL is configured only by an electric circuit which handles only a frequency band not more than the above-described frequency band.

Therefore, in the present embodiment, the VCSEL itself is formed of a configuration that can generate a short pulse by using the semiconductor light emitting element described in the first to fourth embodiments. In this way, a light pulse of about 50 ps to 1 ns, which is preferable for the LiDAR system, is realized while avoiding an increase in cost of the driver unit and the electric transmission unit.

Next, the operation of the ranging device according to the present embodiment will be described with reference to FIG. 14.

First, the control unit 210 outputs a drive signal to the surface emitting laser array driver 212. The surface emitting laser array driver 212 receives the drive signal from the control unit 210 and injects a current of a predetermined current value into the surface emitting laser array 214. Thereby, the surface emitting laser array 214 oscillates, and laser light is output from the surface emitting laser array 214. At this time, the pulse width of the light emitted from the surface emitting laser array 214 is narrower than the pulse width of the injected current, as described above.

The laser light generated by the surface emitting laser array 214 is emitted toward the range to be measured by the light-emitting side optical system 218. Among the laser light irradiated to the object to be measured 1000 in the range to be measured, the laser light reflected by the object to be measured 1000 and incident on the light-receiving side optical system 220 are guided to the image sensor 222 by the light-receiving side optical system 220.

Each pixel of the image sensor 222 generates an electric signal pulse corresponding to the timing at which the laser light is incident. The electric signal pulse generated by the image sensor 222 is input to the distance data processing unit 224.

The distance data processing unit 224 generates information on the distance to the object to be measured 1000 along the light propagation direction based on the reception timing of the electric signal pulse output from the image sensor 222. By calculating distance information based on the electric signal pulse output from each pixel of the image sensor 222, three-dimensional information of the object to be measured 1000 can be acquired.

The ranging device 200 according to the present embodiment may be applied to, for example, in the field of automobiles, a control device for performing control so as not to collide with other vehicles in the field of automobiles, a control device for performing control so as to follow the other vehicles and perform automatic driving, and the like. Further, the ranging device 200 according to the present embodiment may be applied not only to an automobile but also to other movable objects (moving devices) such as a ship, an aircraft, and an industrial robot, a movable object detection system, and the like. The ranging device 200 according to the present embodiment may be widely applied to equipment that utilizes information of an object recognized three-dimensionally, including distance information. These movable objects may be configured to include the ranging device of the present embodiment and a control unit for controlling the movable object based on information about the distance acquired by the ranging device.

The three-dimensional information including the depth that can be acquired by the ranging device 200 according to the present embodiment may also be used in an imaging device, an image processing device, a display device, and the like. For example, it is possible to display a virtual object on an image in the real world without discomfort by using three-dimensional information acquired by the ranging device 200 according to the present embodiment. Further, by storing three-dimensional information together with image information, it is possible to correct a blurred taste or the like of a photographed image after photographing.

As described above, according to the present embodiment, it is possible to realize a high performance ranging device including a light emitting device capable of generating a light pulse having a short light pulse width and a high peak value.

[Sixth Embodiment]

A ranging device according to a sixth embodiment of the present invention will be described with reference to FIG. 15 and FIG. 16. FIG. 15 is a block diagram illustrating a schematic configuration of the ranging device according to the present embodiment. FIG. 16 is a schematic cross-sectional view illustrating a configuration example of a surface emitting laser array in the ranging device according to the present embodiment. Components similar to those of the semiconductor light emitting element according to the first to fourth embodiments and the ranging device according to the fifth embodiment are denoted by the same reference numerals, and description thereof will be omitted or simplified.

The ranging device 200 according to the present embodiment differs from the ranging device according to the fifth embodiment in that the surface emitting laser array 214 further includes a light emission timing monitoring unit 216 as illustrated in FIG. 15. Other points of the ranging device 200 according to the present embodiment are the same as those of the ranging device according to the fifth embodiment.

The surface emitting laser array 214 includes, for example, as illustrated in FIG. 16, a semiconductor light emitting element 100, a light emission timing monitoring unit 216, a base 110, and a window member 120. The base 110 is a part of a package on which the semiconductor light emitting element 100 and the light emission timing monitoring unit 216 are mounted, and has a concave portion for accommodating the semiconductor light emitting element 100 and the light emission timing monitoring unit 216. The base 110 may be made of, for example, ceramic. The window member 120 is fixed to the base 110 so as to close a concave portion of the base 110 on which the semiconductor light emitting element 100 and the light emission timing monitoring unit 216 are mounted. The semiconductor light emitting element 100 is the semiconductor light emitting element 100 according to the fourth embodiment. The light emission timing monitoring unit 216 is formed of a semiconductor substrate having a square shape of, for example, 0.3 mm square, and includes a photodiode having a diameter of the light receiving area of, for example, 100 $\mu$m.

The anode common electrode 40C, the cathode common electrode 42C of the semiconductor light emitting element 100, and an anode and a cathode of the photodiode constituting the light emission timing monitoring unit 216 are electrically connected to corresponding electrodes (not illustrated) provided on the outer peripheral portion of the base 110. The pulse current supplied from the surface emitting laser array driver 212 is supplied to the semiconductor light emitting element 100 via the electrodes provided on the base 110. The electric signal generated by the light emission timing monitoring unit 216 is supplied to the distance data processing unit 224 via electrodes provided on the base 110.

Next, the operation of the ranging device according to the present embodiment will be described with reference to FIG. 15 and FIG. 16.

First, the control unit 210 outputs a drive signal to the surface emitting laser array driver 212. The surface emitting laser array driver 212 receives the drive signal from the control unit 210, and injects a current of a predetermined current value into the semiconductor light emitting element 100 of the surface emitting laser array 214. Thereby, the semiconductor light emitting element 100 oscillates, and laser light is output from the semiconductor light emitting element 100. At this time, the pulse width of the light emitted from the semiconductor light emitting element 100 is narrower than the pulse width of the injected current, as described above.

The laser light generated by the semiconductor light emitting element 100 is emitted from the surface emitting laser array 214 through the window member 120, and is emitted toward the range to be measured by the light-emitting side optical system 218. At this time, although AR coating is applied to the window member 120, a part of the light is reflected by the window member 120 and is incident on the light emission timing monitoring unit 216.

The light emission timing monitoring unit 216 converts the incident light into an electric signal and outputs the electric signal to the distance data processing unit 224. The distance data processing unit 224 generates information on the distance to the object to be measured 1000 along the light propagation direction based on the time difference between the reception timing of the electric signal pulse from the image sensor 222 and the reception timing of the electric signal from the light emission timing monitoring unit 216. The three-dimensional information of the object to be measured 1000 is acquired by calculating distance information based on the electric signal pulse output from each pixel of the image sensor 222.

Next, the reason why the ranging device is configured in this manner in the present embodiment will be described with reference to FIG. 17 and FIG. 18.

In the LiDAR system, the distance to the object to be measured is calculated based on the time difference from the emission of the laser light to the return of the laser light from the object to be measured. Therefore, in order to improve the distance measurement accuracy, it is necessary to know the timing at which the light pulse is generated in the semiconductor light emitting element 100 with higher accuracy. For example, when a time detection accuracy on the light-receiving side is about 50 ps, the accuracy of information on the timing of the pulse generation on the light-emitting side is preferably smaller than 50 ps.

In a general VCSEL and a LiDAR system using the same, a pulse current is generated by a VCSEL driver to drive the VCSEL. Since the VCSEL emits light in accordance with the pulse current waveform, the difference between the emission timing of the VCSEL and the rising timing of the pulse current generated in the VCSEL driver is small, and the time difference does not largely change due to a variation in the environmental temperature or the like. This is because the design of the VCSEL is designed to emit light according to the injected current value. Therefore, it is possible to accurately estimate the time from the generation timing of the current pulse in the driver to the emission timing of the VCSEL.

On the other hand, the inventors of the present invention have found for the first time that when the time difference between the generation timing of the current pulse and the generation timing of the light pulse is estimated by the above-described method, the distance measurement accuracy may be reduced in the LiDAR system using the semiconductor light emitting elements of the first to fourth embodiments in some cases.

In the semiconductor light emitting elements according to the first to fourth embodiments, carriers are accumulated in the active layer 24, and the accumulated carriers are converted into light after the start of laser oscillation to generate the light pulse. That is, the current injected into the semiconductor light emitting element for a predetermined period of time until carriers are accumulated in the active layer 24 is used to accumulate carriers in the active layer 24. Thus, laser oscillation of the semiconductor light emitting element is delayed for the predetermined period of time until carriers are accumulated in the active layer 24.

The timing of laser oscillation in the semiconductor light emitting elements according to the first to fourth embodiments is determined by the structure of the semiconductor light emitting element and the physical parameters of the materials constituting each part. Therefore, even if the current waveform generated by the surface emitting laser array driver 212 is the same, the time difference from the start of driving to the start of laser oscillation changes due to a change in environmental temperature or a change in physical parameters over time. The time difference may exceed about 50 ps, which is a typical time detection accuracy on the light receiving side.

FIG. 17 and FIG. 18 are graphs illustrating the results obtained by calculating the change in the light waveform due to the change in the environmental temperature and the change in the physical parameter over time. FIG. 17 illustrates the calculation result in the case of a general VCSEL, and FIG. 18 illustrates the calculation result in the case of a semiconductor light emitting element according to the present invention.

FIG. 17 and FIG. 18 illustrate enlarged light waveforms immediately after the start of oscillation when the transparency carrier density at room temperature is assumed and when the transparency carrier density at 50 °C higher than room temperature is assumed. In any of the figures, the characteristic at which oscillation starts first is the case that the transparency carrier density at room temperature is assumed, and the characteristic at which oscillation starts later is the case that the transparency carrier density at 50 °C higher than room temperature is assumed.

In the general VCSEL, as illustrated in FIG. 17, the time difference between the peak of the light pulse when the transparency carrier density at room temperature is assumed and the peak of the light pulse when the transparency carrier density at 50 °C higher than room temperature is assumed is 13 ps.

On the other hand, in the semiconductor light emitting element according to the present invention, as illustrated in FIG. 18, the time difference between the peak of the light pulse when the transparent carrier density at room temperature is assumed and the peak of the light pulse when the transparency carrier density at 50 °C higher than room temperature is 70 ps. The time difference from the timing at which the injection of current into the semiconductor light emitting element 100 starts to the timing at which the light output reaches the maximum peak value may vary, for example, in a range of 50 ps or more and 1 ns or less due to a change in environmental temperature.

As described above, in the semiconductor light emitting element according to the present invention, the change in the physical property value greatly affects the change in the oscillation timing. The amount of change in the oscillation timing may exceed about 50 ps, which is a typical time detection accuracy on the light receiving side.

From such a viewpoint, in the ranging device 200 according to the present embodiment, the emission timing of the surface emitting laser array 214 is detected by the light emission timing monitoring unit 216. The distance information is calculated using the light emission timing detected by the light emission timing monitoring unit 216. Therefore, even if the light emission timing of the surface emitting laser array 214 deviates due to factors such as the environmental temperature, it is possible to maintain high distance measurement accuracy without affecting the distance measurement accuracy of the ranging device 200.

As described above, according to the present embodiment, in the ranging device using the light pulse having a high peak value and a short pulse, it is possible to reduce the influence on the distance measuring accuracy due to a change in the environmental temperature or the like.

[Modified Embodiments]

The present invention is not limited to the above-described embodiments, and various modifications are possible.

For example, an example in which some of the configurations of any of the embodiments are added to other embodiments or an example in which some of the configurations of any of the embodiments are substituted with some of the configurations of the other embodiments is also an embodiment of the present invention.

Although GaAs, AlGaAs, and InGaAs are exemplified as semiconductor materials capable of crystal growth when a GaAs substrate is used as the semiconductor substrate 10 in the first to third embodiments, the semiconductor substrate 10 is not limited to the GaAs substrate. For example, an InP substrate may be used as the semiconductor substrate 10. Examples of a semiconductor material capable of crystal growth when the InP substrate is used as the semiconductor substrate 10 include InP, InGaAs, InGaP, InGaAsP, and the like.

The DBR layer in the semiconductor light emitting elements according to the first to third embodiments is not necessarily formed of a semiconductor material, and may be formed of a material other than a semiconductor material. In this case as well, the same effect as that of the present embodiment can be obtained by configuring so as to achieve the same functions as those of the first to third embodiments.

It should be noted that any of the above-described embodiments is merely an example of an embodiment for carrying out the present invention, and the technical scope of the present invention should not be construed as being limited thereto. That is, the present invention can be implemented in various forms without departing from the technical idea or the main features thereof.

The present invention is not limited to the above embodiment, and various changes and modifications can be made without departing from the spirit and scope of the present invention. Accordingly, the following claims are appended in order to publicize the scope of the invention.

This application claims the benefit of Japanese Patent Application No. 2021-083105 filed May 17, 2021 and Japanese Patent Application No. 2022-065143 filed April 11, 2022, which are hereby incorporated by reference herein in their entirety.

[Reference Signs List]

10 ... semiconductor substrate
12, 30 ... lower DBR layer
14 ... non-doped spacer
16 ... saturable absorption layer
18, 32 ... resonator
20 ... n-type layer
22 ... non-doped spacer
24, 34 ... active layer
26 ... p-type layer
28, 36 ... upper DBR layer
38 ... oxidized confinement layer
40, 42 ... Electrode
44 ... protective film
50 ... light-emitting portion
100 ... semiconductor light emitting element
200 ... ranging device

**Claims**

1. A light emitting device comprising:

   a semiconductor light emitting element including a first reflector, a resonator spacer including an active layer, and a second reflector stacked in this order over a semiconductor substrate,
   wherein the semiconductor light emitting element includes a saturable absorption layer provided between the semiconductor substrate and the second reflector, and
   wherein the semiconductor light emitting element is configured to emit light having a profile that has a maximum peak value and converges to a stable value of a predetermined light intensity after the maximum peak value.

2. A light emitting device comprising:

   a semiconductor light emitting element including a first reflector, a resonator spacer including an active layer, and a second reflector stacked in this order over a semiconductor substrate,
   wherein the semiconductor light emitting element includes a saturable absorption layer provided between the semiconductor substrate and the second reflector, and
   wherein the semiconductor light emitting element satisfies the following relationship:

   $$\Gamma s \times gmax(Iop) > \Gamma a \times \alpha 2 + \alpha m + \alpha i$$

   where $\Gamma s$ is an optical confinement coefficient of the active layer; $\Gamma a$ is an optical confinement coefficient of the saturable absorption layer; $gmax(Iop)$ is a maximum gain in the active layer obtained when a current value injected from a driving unit is $Iop$; $\alpha 2$ is an absorption coefficient of the saturable absorption layer; $\alpha m$ is a mirror loss; and $\alpha i$ is a light absorption by carriers.

3. The light emitting device according to claim 1 or 2, wherein the saturable absorption layer is positioned between the semiconductor substrate and the active layer and serves as the first reflector.

4. The light emitting device according to claim 1 or 2, wherein the saturable absorption layer is positioned between the active layer and the second reflector.

5. The light emitting device according to claim 1, wherein a half width value of a light pulse indicating the maximum peak value is not less than 50 ps.

6. The light emitting device according to claim 1, wherein a time difference between a timing of starting an injection of a current into the semiconductor light emitting element and a timing at which a light output reaches the maximum peak value is not less than 50 ps and not more than 1ns.

7. The light emitting device according to any one of claims 1 to 6, wherein the active layer includes a plurality of quantum well layers and a plurality of barrier layers provided between the plurality of quantum well layers, and an energy difference between an emission level of the quantum well layer and a band gap of the barrier layer is in a range of 105 meV to 230 meV.

8. The light emitting device according to claim 7,

   wherein the quantum well layers are formed of InGaAs, and
   wherein the barrier layers are formed of GaAs.

9. The light emitting device according to any one of claims 1 to 8, further comprising a semiconductor layer provided between the active layer and the saturable absorption layer,
   wherein the semiconductor layer includes an AlGaAs layer having an Al composition of a range of 0.45 to 0.9.

10. The light emitting device according to claim 9, wherein the semiconductor layer further includes a GaAsP layer.

11. The light emitting device according to any one of claims 1 to 10, wherein an optical thickness of the resonator spacer is not less than a thickness corresponding to 5 times a resonance wavelength.

**12.** The light emitting device according to any one of claims 1 to 11, wherein an optical thickness of the resonator spacer is not less than a thickness corresponding to 11 times a resonance wavelength.

**13.** The light emitting device according to any one of claims 1 to 12, wherein the active layer includes 6 to 50 quantum well layers.

**14.** The light emitting device according to any one of claims 1 to 13, further includes a light receiving element mounted on the same package as the semiconductor light emitting element and configured to receive light emitted from the semiconductor light emitting element.

**15.** A light emitting device comprising:

a semiconductor light emitting element including a first reflector, a resonator spacer including an active layer, and a second reflector stacked in this order over a semiconductor substrate,
wherein the active layer includes 6 to 50 quantum well layers,
wherein the semiconductor light emitting element further includes a saturable absorption layer provided between the semiconductor substrate and the second reflector, and
wherein an optical thickness of the resonator spacer is not less than a thickness corresponding to 5 times a resonance wavelength.

**16.** The light emitting device according to claim 15, wherein the active layer is positioned between an antinode and a node of a standing wave generated between the first reflector and the second reflector.

**17.** A light emitting device comprising:

a semiconductor light emitting element including a first reflector, a resonator spacer including an active layer, and a second reflector stacked in this order over a semiconductor substrate,
wherein the semiconductor light emitting element includes a saturable absorption layer provided between the semiconductor substrate and the second reflector, and
wherein the active layer includes a plurality of quantum well layers and a plurality of barrier layers provided between the plurality of quantum well layers, and
wherein the barrier layers are formed of GaAs.

**18.** The light emitting device according to claim 17, wherein an optical thickness of the resonator spacer is not less than a thickness corresponding to 5 times a resonance wavelength.

**19.** The light emitting device according to any one of claims 15 to 18, wherein an optical thickness of the resonator spacer is not less than a thickness corresponding to 11 times a resonance wavelength.

**20.** A ranging device comprising:

the light emitting device according to any one of claims 1 to 19;
a light receiving device configured to receive light emitted from the light emitting device and reflected by an object to be measured; and
a distance information acquisition unit configured to acquire information on a distance to the object to be measured based on a time difference between a timing at which light is emitted from the light emitting device and a timing at which light is received by the light receiving device.

**21.** A movable object comprising:

the ranging device according to claim 20; and
a control unit configured to control the movable object based on information on the distance acquired by the ranging device.

# FIG. 1

# FIG. 2

# FIG. 3

# FIG. 4

# FIG. 5

# FIG. 6

# FIG. 7

# FIG. 8

$L_{eff}$ : EFFECTIVE RESONATOR LENGTH

$L_{eff}$ = 2μm

$L_{eff}$ = 5μm

$L_{eff}$ = 10μm

PEAK VALUE RATIO

NUMBER OF QUANTUM WELL LAYERS

# FIG. 9

# FIG. 10

# FIG. 11

# FIG. 12

# FIG. 13

# FIG. 14

FIG. 15

# FIG. 16

FIG. 17

# FIG. 18

## INTERNATIONAL SEARCH REPORT

| International application No. |
|---|
| **PCT/JP2022/020072** |

**A. CLASSIFICATION OF SUBJECT MATTER**

*H01S 5/183*(2006.01)i; *G01C 3/06*(2006.01)i; *G01S 7/481*(2006.01)i; *G01S 7/484*(2006.01)i; *H01S 5/02325*(2021.01)i; *H01S 5/062*(2006.01)i
FI: H01S5/183; H01S5/062; H01S5/02325; G01S7/481 A; G01S7/484; G01C3/06 140; G01C3/06 120Q

According to International Patent Classification (IPC) or to both national classification and IPC

**B. FIELDS SEARCHED**

Minimum documentation searched (classification system followed by classification symbols)

H01S5/00-5/50; G01C3/06; G01S7/48-7/51

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2020-524910 A (TRUMPF PHOTONIC COMPONENTS GMBH) 20 August 2020 (2020-08-20) paragraphs [0036]-[0042], [0048], fig. 1-7, 11 | 1-2, 6, 14, 20-21 |
| Y | | 5, 7-8, 13, 17 |
| A | | 3-4, 9-12, 15-16, 18-19 |
| Y | US 2015/0311673 A1 (PRINCETON OPTRONICS INC.) 29 October 2015 (2015-10-29) paragraphs [0050]-[0061], [0090], [0091], fig. 1, 2, 13, 14 | 5, 13 |
| Y | JP 11-511292 A (HONEYWELL INC.) 28 September 1999 (1999-09-28) page 10, line 28 to page 11, line 18 | 7-8, 17 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **30 June 2022** | **12 July 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.

**PCT/JP2022/020072**

| Patent document cited in search report | | | Publication date (day/month/year) | Patent family member(s) | | | Publication date (day/month/year) |
|---|---|---|---|---|---|---|---|
| JP | 2020-524910 | A | 20 August 2020 | US 2020/0161833 A1 paragraphs [0047]-[0053], [0057], fig. 1-7, 11 WO 2018/234131 A1 EP 3419123 A1 CN 110892596 A KR 10-2020-0024845 A | | | |
| US | 2015/0311673 | A1 | 29 October 2015 | (Family: none) | | | |
| JP | 11-511292 | A | 28 September 1999 | US 5574738 A column 4, lines 32-58 WO 1996/041403 A1 | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020148512 A
- JP 2021083105 A
- JP 2022065143 A